Europäisches Patentamt

European Patent Office

Office européen des brevets

(19)

(11) Publication number: **0 072 751
B1**

(12) **EUROPEAN PATENT SPECIFICATION**

(45) Date of publication of patent specification: **08.01.86**

(21) Application number: **82401522.6**

(22) Date of filing: **11.08.82**

(51) Int. Cl.⁴: **H 03 L 7/08**

(54) **Phase-locked loop circuit.**

(30) Priority: **12.08.81 JP 126248/81**

(43) Date of publication of application:
**23.02.83 Bulletin 83/08**

(45) Publication of the grant of the patent:
**08.01.86 Bulletin 86/02**

(84) Designated Contracting States:
**DE FR GB**

(56) References cited:
**IEEE JOURNAL OF SOLID-STATE CIRCUITS,
vol. SC-16, no. 4, August 1981, pages 315-321,
New York, USA A. IWATA et al.: "A single-chip
codec with switched-capacitor filters"**

**IEEE TRANSACTIONS ON ACOUSTICS, SPEED
& SIGNAL PROCESSING, vol. ASSP-29, no. 3,
part III, June 1981, pages 736-744, New York,
USA K. MARTIN, et al.: "Switched-capacitor
building blocks for adaptive systems"**

(73) Proprietor: **Nippon Telegraph and Telephone
Corporation
1-6 Uchisaiwaicho 1-chome Chiyoda-ku
Tokyo (JP)**

(73) Proprietor: **FUJITSU LIMITED
1015, Kamikodanaka Nakahara-ku
Kawasaki-shi Kanagawa 211 (JP)**

(72) Inventor: **Iwata, Atsushi
Kotesashi-haitsu F 502 1-17-1, Kotesashi-cho
Tokorozawa-shi Saitama 359 (JP)**
Inventor: **Kaneko, Takao
Tomomihara Dokushinryo 4-2978, Mihara-cho
Tokorozawa-shi Saitama 359 (JP)**
Inventor: **Ito, Akihiko
3780, Suge Tama-ku
Kawasaki-shi Kanagawa 214 (JP)**
Inventor: **Saito, Tadahiro
Nagasaki-so 520, Shinsaku Takatsu-ku
Kawasaki-shi Kanagawa 213 (JP)**
Inventor: **Fukui, Hirokazu
Takei-so 449, Miyauchi Nakahara-ku
Kawasaki-shi Kanagawa 211 (JP)**

(74) Representative: **Descourtieux, Philippe et al
CABINET BEAU de LOMENIE
55 rue d'Amsterdam
F-75008 Paris (FR)**

EP 0 072 751 B1

## Description

Field of the invention

The present invention relates to a phase-locked loop (PLL) circuit. More particularly, it relates to a PLL circuit of the type including:

— a phase comparator for generating a first phase difference signal and a second phase difference signal in response to a positive or negative phase difference between a first input signal and a second input signal, respectively,
— a loop filter for generating a control voltage corresponding to said phase difference terminal for receiving the first phase difference signal, a second input terminal for receiving the second phase difference signal and an output terminal for outputting the control voltage,
— a voltage controlled oscillator controlled by said control voltage, and
— a feed back means connected between the voltage controlled oscillator and the phase comparator.

Background of the invention

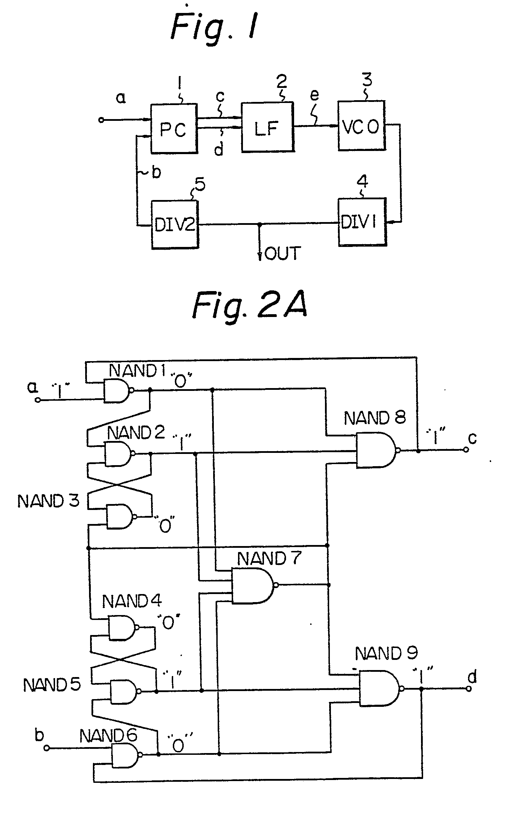

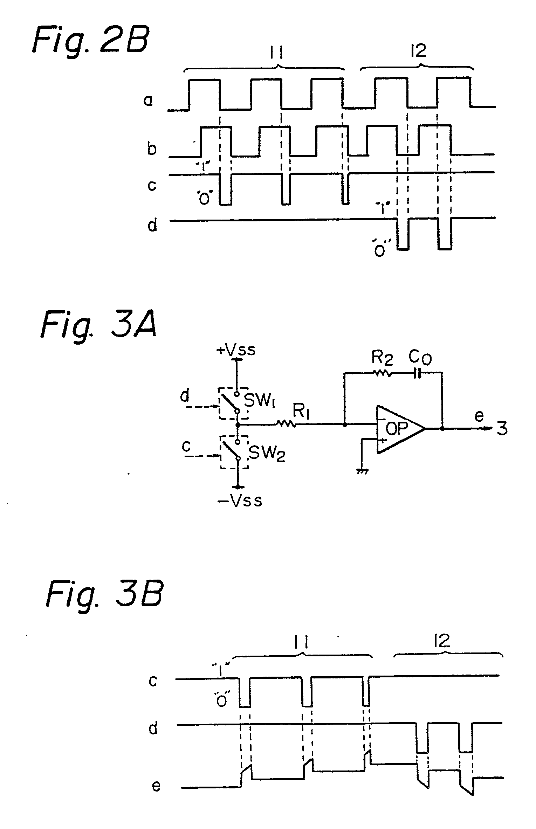

A PLL circuit usually has a phase comparator PC, a loop filter LF, and a voltage-controlled oscillator VCO, an output signal of a frequency corresponding to the oscillation frequency of the voltage-controlled oscillator being supplied to the phase comparator to compare the phase with the phase of an input signal. Such a PPL circuit is shown in Fig. 1 of the accompanying drawings. Figs. 2A and 3A show respectively an embodiment of the phase comparator and of the loop filter. Figs. 1, 2A, 3A will be described in more detail hereinafter, as well as Figs. 2B and 3B which illustrate time charts of waveforms at input and output terminals of the circuits of Figs. 2A and 3A.

In all PLL circuit, an active filter such as the one of Fig. 3A is conventionally used as the loop filter. Reference can also be made to Fig. 8(b) and the corresponding description in IEEE Journal of Solid State Circuits, Vol SC-16, no. 4, August 1981, pp. 315—321 (A. Iwata et al.: "A single-chip codec with switched capacitor filters").

The transfer function F(S) of the filter of Fig. 3A is given by the following equation:

$$F(S) = \frac{S\tau_2 + 1}{S\tau_1}$$

where $\tau_1 = R_1 \cdot C_0$ and $\tau_2 = R_2 \cdot C_0$, $R_1$ and $R_2$ are resistors, and $C_0$ is a capacitor used in the active RC filter.

When the PLL circuit is formed in the form of an integrated circuit and is used for a coder-decoder circuit, the resistance in the integrated circuit should be about one hundred kilohms at the most. Therefore, if $R_1$ is set to be 2.08 kilohms and $R_2$ to be 28.6 kilohms, capacity $C_0$ must have a capacity of 10,000 pF. Capacitor $C_0$ in the inte-

grated circuit consists of a polycrystalline silicon first layer that serves a first electrode, a polycrystalline silicone second layer that serves as a second electrode, and a silicon dioxide ($SiO_2$) that is sandwiched therebetween and that serves as a dielectric member. To obtain a capacity of 10,000 pF, however, capacitor $C_0$ must be 4 to 5 mm in diameter, which diameter is very large in relation to the size of the transistor, which measures several tens of microns in diameter, and defeats the purpose of constructing the circuit in the form of an integrated circuit.

Objects of and summary of the invention

An object of the present invention is to provide a PLL circuit having a loop filter circuit which, compared to the above mentioned conventional filters, uses a smaller capacitor while showing equivalent characteristics, allowing then to easily form the PLL circuit as an integrated circuit.

The above-mentioned objects can be achieved by a phase-locked loop circuit of the type defined at the beginning of this description wherein, according to the invention, the loop filter comprises:

a first, a second and a third capacitors each having a pair of terminals one of which is connected to the output terminal,

a means for charging the first capacitor during a period in which the first phase difference signal is generated and discharging the first capacitor during a period in which the second phase difference signal is generated,

a first switching means connected to the other terminal of the second capacitor for supplying a first pulse signal when the first phase difference signal is generated, and

a second switching means connected to the other terminal of the third capacitor for supplying a second pulse signal when the second phase difference signal is generated.

Further features and advantages of the present invention will be apparent from the ensuing description with reference to the accompanying drawings to which, however, the scope of the invention is in no way limited.

Brief description of the drawings

Figure 1 is a block diagram illustrating an example of the PLL circuit;

Fig. 2A is a block diagram illustrating a general phase comparator, and Fig. 2B is a time chart of the waveforms of the input and output of the circuit shown in Fig. 2A;

Fig. 3A is a diagram illustrating a conventional loop filter, and Fig. 3B is a time chart of the waveforms of the input and output of the circuit shown in Fig. 3A;

Fig. 4 is a diagram illustrating a loop filter according to the present invention;

Fig. 5A is a circuit of one embodiment of the loop filter according to the present invention, and Fig. 5B is a time chart of the waveforms of the input and output of the circuit shown in Fig. 5A; and

Figs. 6A and 6B are diagrams illustrating other embodiments of the loop filter circuit according to the present invention.

## Detailed explanation of the invention

The PLL circuit usually has, as shown in Fig. 1, phase comparator 1, loop filter 2, and voltage-controlled oscillator 3, signal b of a frequency corresponding to the oscillation frequency of the voltage-controlled oscillator 3 being supplied into the phase comparator to compare the phase with the phase of input signal a.

In the PLL circuit, furthermore, frequency dividers 4 and 5 are provided in order to divide the frequency (512 KHz) of the signal produced by the voltage-controlled oscillator by four through frequency divider 4, i.e., to obtain a frequency of 128 KHz, and to further divider the frequency by 16 through frequency divider 5 to obtain signal b having a frequency of 8 KHz, thereby comparing the phase of signal a with the phase of signal b through phase comparator 1. By using a circuit of this construction, signals having a frequency of 128 KHz are stably obtained through output terminal OUT.

When the phase of signal a is in agreement with the phase of signal b, the phase comparator produces outputs c and d, which are both "1". Upon receipt of outputs "1", therefore, loop filter 2 maintains control voltage e, which is supplied to voltage-controlled oscillator 3 unchanged.

When the phase of signal a is in advance of the phase of signal b, signal c becomes "0" and signal d becomes "1". Upon receipt of these signals, loop filter 2 sends control voltage e to voltage-controlled oscillator 3 so that the oscillation frequency increases.

Therefore, the oscillation frequency of voltage-controlled oscillator 3 increases so that the phase of signal b is in agreement with the phase of signal a.

When the phase of signal a lags behind the phase of signal b, on the other hand, signal c becomes "1" and signal d becomes "0". Upon receipt of these signals, therefore, loop filter 2 sends control voltage e to voltage-controlled oscillator 3 so that the oscillation frequency decreases.

Therefore, the oscillation frequency of voltage-controlled oscillator 3 decreases so that the phase of signal b is in agreement with the phase of signal a.

Figure 2A illustrate the construction of phase comparator circuit 1 which produces signals c and d in response to signals a and b. Fig. 2B is a timing chart.

In Figs. 2A, phase comparator 1 consists of NAND gates 1 to 9. NAND gate 1 receives signal a of Fig. 1, NAND gate 6 receives signal b, NAND gate 8 produces signal c, and NAND gate 9 produces signal d.

When the phase of signal a is in advance of the phase of signal b as shown in Fig. 2B, signal c bscomes "0" by a width that corresponds to the deviation in phase between signal a and b, and signal d maintains the level "1", as indicated by 11.

On the other hand, when the phase of signal a lags behind the phase of signal b, signal d becomes "0" by a width that corresponds to the deviation in phase between signal a and signal b, and signal c maintains the level "1", as indicated by 12.

Signals c and d produced by the phase comparator in response to the phase deviation between signals a and b are supplied to the loop filter which is shown in Fig. 3A.

Figure 3A is a diagram illustrating a conventional loop filter which consists of switches $SW_1$ and $SW_2$ connected in series between power-supply terminals $+V_{SS}$ and $-V_{SS}$, operational amplifier OP in which a first input terminal is connected to the connecting point of the switches through resistor $R_1$, and resistor $R_2$ and capacitor $C_0$, which are connected in series across the input terminal and the output terminal of the operational amplifier and which constitute a feedback loop. A second input terminal of the operational amplifier OP is grounded.

Switches $SW_1$ and $SW_2$ are, respectively, rendered conductive when signals d and c become the level "0" and are rendered nonconductive when signals d and c become the level "1".

Therefore, when the phase of signal a is in agreement with the phase of signal b, signals c and d become the level "1" and, hence, switches $SW_1$ and $SW_2$ are both rendered nonconductive. so that output voltage e corresponding to the electric charge stored in capacitor $C_0$ is sent to voltage-controlled oscillator 3.

When the phase of signal a is in advance of the phase of signal b as indicated by 11 in the timing chart of Fig. 3B, signal c, which becomes the level "0", renders switch $SW_2$ conductive so that the electric charge stored in capacitor $C_0$ is discharged to $-V_{SS}$ through resistors $R_1$ and $R_2$.

When operational amplifier OP is in operation, the potential at the first input terminal is equal to the potential at the second input terminal, i.e., equal to zero volts. Therefore, the larger the amount of electric charge stored in capacitor $C_0$, the smaller output voltage e. When switch $SW_2$ is turned on so that the electric charge stored in capacitor $C_0$ is discharged, output voltage e increases, as shown in Fig. 3B.

When the phase of signal a lags behind the phase of signal b as indicated by 12, on the other hand, signal d, which becomes the level "0", causes switch $SW_1$ to be turned on so that the electric charge is stored in capacitor $C_0$ from power supply $+V_{SS}$ via resistors $R_1$ and $R_2$. Therefore, contrary to the case of when the electric charge is discharged, output voltage 4 decreases as shown in Fig. 3B.

Output voltage e is thus supplied to the voltage-controlled oscillator in response to the relation of the phase between signals a and b.

The above-mentioned loop filter, however, has the defects described below.

Namely, a loop filter of this type is usually called an active RC filter. Its transfer function F(S) is given by the following equation (1)

$$F(S) = \frac{S\tau_2 + 1}{S\tau_1} \qquad (1)$$

where $\tau_1 = R_1 \cdot C_0$ and $\tau_2 = R_2 \cdot C_0$

If the circuit of Fig. 1 is constructed in the form of an integrated circuit and is employed as a coder/decoder circuit, $\tau_1$ will be set to $2.09 \times 10^{-3}$ seconds, and $\tau_2$ will be set to $2.86 \times 10^{-4}$ seconds.

Generally, the resistance in an integrated circuit should be about several hundred kilohms at the most. Therefore, if $R_1$ is set to be 2.08 kilohms and $R_2$ to be 28.6 kilohms, the capacitor $C_0$ must be 10,000 pF. Capacitor $C_0$ in the integrated circuit consists of a polycrystalline silicon first layer that serves as a second electrode, and silicon dioxide ($SiO_2$) that is sandwiched therebetween and that serves as a dielectric member. To obtain a capacity of 10,000 pF, however, capacitor $C_0$ must be 4 to 5 mm in diameter, which diameter is very large in relation to the size of the transistor, which measures several tens of microns in diameter, and defeats the purpose of constructing the circuit in the form of an integrated circuit.

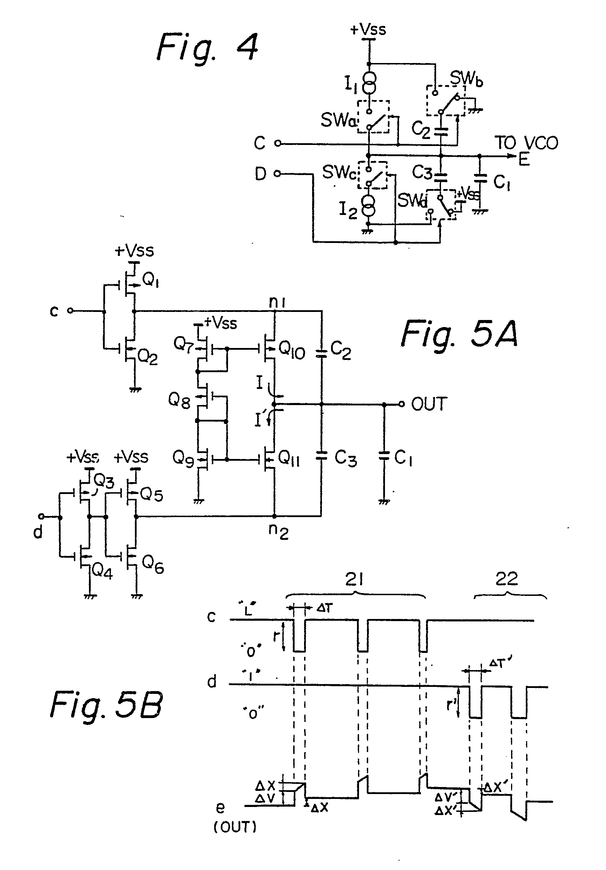

Fig. 4 is a block diagram which illustrates an embodiment of the present invention. In Fig. 4, capacitor $C_1$ is connected to an output terminal, capacitors $C_2$ and $C_3$ have a terminal connected to the output terminal, and $I_1$ and $I_2$ are constant-current sources. Pairs of switches [$SW_a$ and $SW_b$] and [$SW_c$ and $SW_d$] are switched by inputs C and D, which correspond to the phase difference. That is, when a signal is received at input terminal C, the pair of switches $SW_a$ and $SW_b$ is actuated so that a predetermined voltage is supplied to another terminal of capacitor $C_2$ and capacitor $C_1$ is charged by constant-current source $I_1$. When a signal is received at input terminal D, the pair of switches $SW_c$ and $SW_d$ is actuated so that the another terminal of capacitor $C_3$ is grounded and capacitor $C_1$ is discharged by constant-current source $I_2$. When no signal is supplied to either of input terminals C and D, said another terminal of capacitor $C_3$ is grounded and the another terminal of the capacitor $C_3$ is supplied with a predetermined voltage. In the circuit shown in Fig. 4, capacitors $C_1$, $C_2$, and $C_3$ can be realized as several pF to several hundred pF, and the value of $I_1$ and $I_2$ is on the order of several tens of nano-amperes to several tens of micro-amperes. Therefore the circuit shown in Fig. 4 can be formed as an integrated circuit.

Figure 5A is a diagram which illustrates an embodiment of the present invention, in which $Q_1$ to $Q_{11}$ denote transistors and $C_1$, $C_2$, and $C_3$ denote capacitors.

P-channel transistor $Q_1$ and n-channel transistor $Q_2$ constitute a first switch ($SW_a$ in Fig. 4), and signal is supplied to the commonly connected gates of transistors $Q_1$ and $Q_2$.

Transistors $Q_3$, $Q_4$, $Q_5$, and $Q_6$ constitute a second switch ($SW_c$ in Fig. 4), and signal d is supplied to the commonly connected gates of transistors $Q_3$ and $Q_4$.

Transistors $Q_7$, $Q_8$, and $Q_9$ are connected in series between power supply $+V_{SS}$ and the ground, and the gates of the individual transistors are connected to their drains so that an electric current is allowed to flow from power supply $+V_{SS}$ to the ground at all times. The gate of p-channel transistor $Q_{10}$ is connected to the drain of transistor $Q_7$, and the gate of n-channel transistor $Q_{11}$ is connected to the drain of transistor $Q_8$.

The connecting point between transistor $Q_{10}$ and transistor $Q_{11}$ serves as output terminal OUT of the loop filter, and first capacitor $C_1$, second capacitor $C_2$, and third capacitor $C_3$ are connected to the output terminal.

The first and second switches exhibit not only the function of switching transistors $Q_{10}$ and $Q_{11}$ but also the function of driving capacitors $C_2$ and $C_3$.

Operation of the circuit will be described below referring to Fig. 5B.

When the phase of signal a (see Fig. 1) is in advance of the phase of signal b (see Fig. 1) signal d becomes the level "1" when signal c is the level "0" as indicated by 21 of Fig. 5B. In response to signal c of the level "0", therefore, p-channel transistor $Q_1$ is rendered conductive and n-channel transistor $Q_2$ nonconductive so that the potential at point $N_1$ becomes a high level.

In this case, the potential at output terminal OUT of the loop filter increases by $\Delta V$ via capacitor $C_2$ as denoted by e in Fig. 5B. If the capacity of each of the capacitors $C_1$, $C_2$, and $C_3$ is denoted by $C_1$, $C_2$, and $C_3$ and if the rising width at point $n_1$ is denoted by V when signal c changes from "1" to "0", increment $\Delta V$ is given by the following equation (2).

$$\Delta V = \frac{C_2}{C_1 + C_2 + C_3} \cdot V \qquad (2)$$

At the same time, since the potential at point $n_1$ becomes a high level, the source potential of p-channel transistor $Q_{10}$ becomes greater than the gate potential by more than its threshold value. Therefore, transistor $Q_{10}$ is rendered conductive (at this time, the potential at point $n_2$ becomes a high level, and n-channel transistor $Q_{11}$ is rendered non-conductive), and current I is allowed to flow to output terminal OUT via transistor $Q_{10}$ for a period of time corresponding to width $\Delta T$ during which time signal c becomes the level "0". Therefore, the potential at output terminal OUT is further increased by $\Delta X$ in addition to increment $\Delta V$.

Increment $\Delta X$ is given by the following equation (3)

$$\Delta X = \frac{I \cdot \Delta T}{C_1 + C_2 + C_3} \qquad (3)$$

As the level of signal c changes from "0" to "1", there is no potential increment $\Delta V$ at output terminal OUT via capacitor $C_2$. Only potential increment $\Delta X$ is left owing to current I that flows through transistor $Q_{10}$ for the period of time $\Delta T$.

Thus, the potential at output terminal OUT increases every time signal c becomes the level "0" until the phase of signal a is in agreement with the phase of. signal b. Therefore, the potential at output terminal OUT is supplied to the voltage-controlled oscillator as output voltage e of the loop filter so that the oscillation frequency is increased. Accordingly, the phase of signal b is advanced so that it is in agreement with the phase of signal a. When the phase of signal a (Fig. 1) lags behind the phase of signal b (Fig. 1), signal c becomes the level "1" when the signal d is the level "0" as indicated by 22 of Fig. 5B. In response to signal d of the level "0", therefore, p-channel transistor $Q_3$ is rendered conductive and n-channel transistor $Q_4$ nonconductive, and, thereby, the potential at the gates of transistors $Q_5$ and $Q_6$ becomes a high level. Consequently, p-channel transistor $Q_5$ is rendered nonconductive and n-channel transistor $Q_6$ conductive, and the potential at point $n_2$ becomes the low level.

Quite contrary to the above-mentioned case, therefore, the potential at output terminal OUT of the loop filter decreases by potential output terminal OUT of the loop filter decreases by $\Delta V'$ via capacitor $C_3$ as denoted by e in Fig. 5B. Like the above-mentioned case, decrement $\Delta V'$ is given by the following equation (4)

$$\Delta V' = \frac{C_3}{C_1 + C_2 + C_3} \cdot V' \qquad (4)$$

At the same time, since the potential at point $n_2$ becomes a low level, the source potential of the n-channel transistor becomes smaller than the gate voltage by more than its threshold value. Therefore, transistor $Q_{11}$ is rendered conductive (at this time, the potential at point $n_1$ becomes a low level, and p-channel transistor $Q_{10}$ is rendered nonconductive), and current I' (Fig. 5A) is allowed to flow from output terminal OUT to the ground via transistors $Q_{11}$ and $Q_6$ for a period of time corresponding to width T', during in which time signal d becomes the level "0".

Therefore, the potential at output terminal OUT is further decreased by $\Delta X'$ in addition to decrement $\Delta V'$.

Decrement $\Delta X'$ is given by the following equation (5)

$$\Delta X' = \frac{I' \cdot \Delta T'}{C_1 + C_2 + C_3} \qquad (5)$$

As the level of signal d changes from "0" to "1", there is no potential decrement $\Delta V'$ at output terminal OUT through capacitor $C_3$, and only potential decrement $\Delta X'$ is left owing to the flow of current I' (Fig. 5A) through transistor $Q_{11}$ for the period of time $\Delta T'$.

Thus, the potential at output terminal OUT decreases every time signal d becomes the level "0" until the phase of signal a is in agreement with the phase of signal b. The potential at output terminal OUT is supplied to the voltage-controlled oscillator as output voltage e of the loop filter so that the oscillation frequency decreases. Therefore, the phase signal b is delayed so that it is in agreement with the phase of signal a.

In the above-mentioned embodiment, capacitors $C_2$ and $C_3$ have the same capacity, and current I is set to be equal to current I'. Further, since the level "1" of signals c and d is equal to $+V_{ss}$ and the level "0" is equal to the ground level, V is equal to V' and, hence, $\Delta V$ is equal to $\Delta V'$.

According to the circuit of the present invention, as will be obvious from the foregoing description, when the phase of output signal b (inclusive of frequency-divided signals as in the embodiment of the invention) of the voltage-controlled oscillator lags behind the phase of signal a, the potential at output terminal OUT is raised via capacitor $C_2$ and is further raised by capacitor $C_1$ as it is electrically charged through transistor $Q_{10}$ that is rendered conductive at the same time, and, thereby, the oscillation frequency of the voltage-controlled oscillator is increased. When the phase of signal b is in advance of the phase of signal a, the potential at output terminal OUT is lowered via capacitor $C_3$ and is further lowered by capacitor $C_1$ as it loses the electric charge through transistor $Q_{11}$ that is rendered conductive at the same time, and, thereby, the oscillation frequency of the voltage-controlled oscillator is decreased.

The transfer function F(S) of the loop filter is given by the following equation (6)

$$F(S) = \frac{S\tau_2 + 1}{S\tau_1} \cdot V_{ss} \qquad (6)$$

where

$$\tau_1 = \frac{C_1 + C_2 + C_3}{I} \cdot V_{ss}, \quad \tau_2 = \frac{C_2 \cdot V_{ss}}{I}$$

If $\tau_1 = 2.08 \times 10^{-3}$ sec., $\tau_2 = 2.86 \times 10^{-4}$ sec., $V_{ss} = 5$ volts, and I = 0.06 $\mu$A, capacitance $C_1$ will be 18.06 pF, and capacitance $C_2 = C_3$ will be 3.43 pF.

The above capacitances of capacitors $C_1$, $C_2$, and $C_3$ can be realized if they are combined to a size of 300 $\mu$m$\square$ and can hence be employed in integrated circuits.

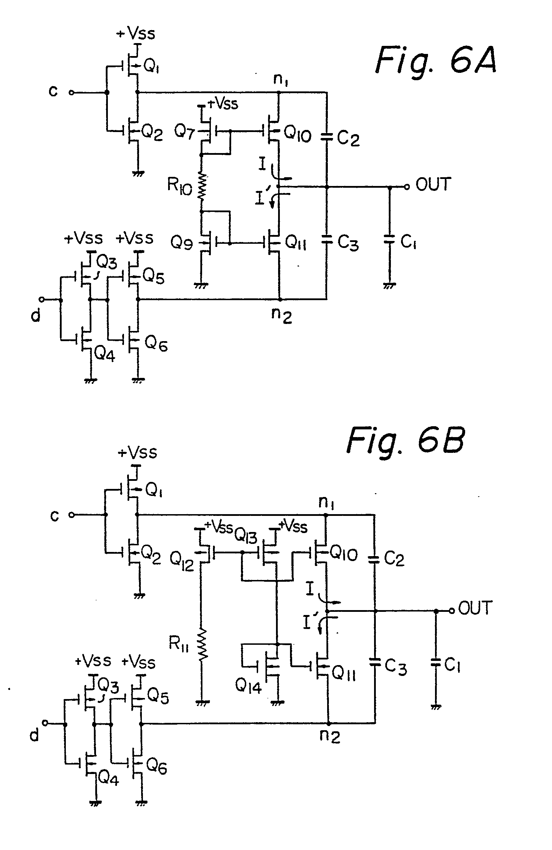

Figures 6A and 6B are other embodiments of the present invention. In Fig. 6A, resistor $R_{10}$ is utilized in place of transistor $Q_8$ in Fig. 5A. The temperature dependency of the resistors is less than the transistor, and, therefore, the circuit shown in Fig. 6A can improve the temperature characteristic as compared to the circuit in Fig.

5A. However, the space necessary for the resistor in the integrated circuit is greater than that necessary for the transistor in the integrated circuit. In Fig. 6B, a constant-current source is formed by transistors $Q_{12}$, $Q_{13}$, and $Q_{14}$ and resistor $R_{11}$. In the circuit in Fig. 6B, the voltage is divided by transistor $Q_{12}$ and resistor $R_{11}$, which has less of a temperature dependency, and, therefore, the temperature characteristic of the constant-current source in circuit 6B can be improved more than the temperature characteristic of the constant-current source in the circuit shown in Fig. 6A.

According to the present invention as mentioned above, the capacitors formed in the loop filter circuit can be sufficiently reduced in size, thereby making it possible to provide a PLL circuit that can be constructed in the form of an integrated circuit.

**Claims**

1. A phase-locked loop circuit which includes:

— a phase comparator for generating a first phase difference signal (c) and a second phase difference signal (d) in response to a positive or negative phase difference between a first input signal (a) and a second input signal (b), respectively,
— a loop filter for generating a control voltage corresponding to said phase difference, said loop filter comprising a first input terminal for receiving the first phase difference signal (c), a second input terminal for receiving the second phase difference signal (d) and an output terminal for outputting the control voltage (e),
— a voltage controlled oscillator controlled by said control voltage, and
— a feed back means connected between the voltage controlled oscillator and the phase comparator, characterized in that said loop filter comprises:

a first, a second and a third capacitors ($C_1$, $C_2$, $C_3$) each having a pair of terminals one of which is connected to the output terminal, a means ($I_1$, $I_2$) for charging the first capacitor ($C_1$) during a period in which the first phase difference signal (c) is generated and discharging the first capacitor ($C_1$) during a period in which the second phase difference signal (d) is generated, a first switching means (SWb) connected to the other terminal of the second capacitor ($C_2$) for supplying a first pulse signal when the first phase difference signal (c) is generated, and a second switching means (SWd) connected to the other terminal of the third capacitor ($C_3$) for supplying a second pulse signal when the second phase difference signal (D) is generated.

2. A phase-locked loop circuit according to claim 1, wherein said charging and discharging means comprises a first transistor ($Q_{10}$) connected to the output terminal, a second transistor ($Q_{11}$) connected to the output terminal,

and a means ($Q_7$, $Q_8$, $Q_9$; $Q_7$, $R_{10}$, $Q_9$; $Q_{12}$, $Q_{13}$, $Q_{14}$, $R_{11}$) for supplying bias voltage to gates of the first and the second transistor respectively.

3. A phase-locked loop circuit according to claim 2, wherein the first transistor is a p-channel transistor ($Q_{10}$, and the second transistor is a n-channel transistor ($Q_{11}$).

4. A phase-locked loop circuit according to claim 2, wherein the bias voltage supplying means comprises (Fig. 5A) a third transistor ($Q_7$), a fourth transistor ($Q_8$) and a fifth transistor ($Q_9$) connected in series, the gate of each one of the third, fourth and fifth transistors being connected to the drain of the same transistor, the gate of the third transistor ($Q_7$) being connected to the gate of said first transistor ($Q_{10}$), and the gate of the fifth transistor ($Q_9$) being connected to the gate of the second transistor ($Q_{11}$).

5. A phase-locked loop circuit according to claim 2, wherein the bias voltage supplying means comprises (Fig. 6A):
a third transistor ($Q_7$) having a gate connected to the gate of the first transistor ($Q_{10}$),
a fourth transistor ($Q_9$) having a plate connected to the gate of the second transistor ($Q_{11}$), and
a resistor ($R_{10}$) connected between the drain of the third transistor and the drain of the fourth transistor, the drain of each one of third and fourth transistors being connected to the gate of the same transistor.

6. A phase-locked loop circuit according to claim 2, wherein the bias voltage supplying means comprises (Fig. 6B), a third transistor ($Q_{13}$) having a gate connected to the gate of the first transistor ($Q_{10}$), a fourth transistor ($Q_{14}$) connected in series with the third transistor, and having a gate connected to its drain, a fourth transistor ($Q_{12}$) having a gate connected to the gate of the third transistor ($Q_{13}$), and a resistor ($R_{11}$) connected in series with the fourth transistor ($Q_{12}$).

7. A phase-locked loop circuit according to claim 1, wherein the first switching means comprises a first inverter ($Q_1$, $Q_2$) connected between the first input terminal and the other terminal of the second capacitor ($C_2$), and the second switching means comprises a second and a third inverters ($Q_3$, $Q_4$; $Q_5$, $Q_6$) connected in series between the second input terminal and the other terminal of the third capacitor ($C_3$).

**Patentansprüche**

1. Phasenstarre Regelkreisschaltung mit:

— einem Phasenkomparator zur Erzeugung eines ersten Phasendifferenzsignals (c) und eines zweiten Phasendifferenzsignals (d) in Abhängigkeit von einer positiven oder negativen Phasendifferenz zwischen einem ersten Eingangssignal (a) bzw. einem zweiten Eingangssignal (b),
— einem Regelfilter zur Erzeugung einer Steuerspannung, die der genannten Phasendifferenz entspricht, welcher Regelfilter einen ersten Eingangsanschluß zum Empfang des ersten Phasendifferenzsignals (c), einen zweiten Eingangsanschluß zum Empfang des zweiten Phasendifferenzsignals (d) und einen Ausgangsanschluß zur Ausgabe der Steuerspannung (e) aufweist,

— einem spannungsgesteuerten Oszillator, der von der genannten Steuerspannung gesteuert wird, und

— einer Rückkopplungseinrichtung, welche zwischen dem spannungsgesteuerten Oszillator und dem Phasenkomparator angeordnet ist, dadurch gekennzeichnet, daß der Regelkreisfilter umfaßt:

einen ersten, einen zweiten und einen dritten Kondensator ($C_1$, $C_2$, $C_3$), die jeweils ein Paar von Anschlüssen aufweisen, von denen einer mit dem Ausgangsanschluß verbunden ist,

Einrichtungen ($I_1$, $I_2$) zum Laden des ersten Kondensators ($C_1$) während einer Periode, in welcher das erste Phasendifferenzsignal (c) erzeugt wird und zur Entladung des ersten Kondensators ($C_1$) während einer Periode, während welcher das zweite Phasendifferenzsignal (d) erzeugt wird,

eine ersten Schalteinrichtung (SWb), die mit dem anderen Anschluß des zweiten Kondensators ($C_2$) verbunden ist, um ein erstes Impulssignal zuzuführen, wenn das erste Phasensignal (c) generiert wird, und

eine zweite Schalteinrichtung (SWd), die mit dem anderen Anschluß des dritten Kondensators ($C_3$) verbunden ist, um ein zweites Pulssignal zuzuführen, wenn das zweite Phasendifferenzsignal (D) erzeugt wird.

2. Phasenstarrer Regelkreis nach Anspruch 1, bei welchem die genannten Lade- und Entladeeinrichtungen einen ersten Transistor ($Q_{10}$), der mit dem Ausgangsanschluß verbunden ist, einen zweiten Transistor ($Q_{11}$), der mit dem Ausgangsanschluß verbunden ist und Einrichtungen ($Q_7$, $Q_8$, $Q_9$; $Q_7$, $R_{10}$, $Q_9$; $Q_{12}$, $Q_{13}$, $Q_{14}$, $R_{11}$) zur Zuführung einer Vorspannung an die Gates des ersten bzw. zweiten Transistors umfassen.

3. Phasenstarrer Regelkreis nach Anspruch 2, bei welchem der erste Transistor ein p-Kanal-Transistor ($Q_{10}$) und der zweite Transistor ein n-Kanal-Transistor ($Q_{11}$) ist.

4. Phasenstarrer Regelkreis nach Anspruch 2, bei welchem die die Vorspannung zuführende Einrichtung (Fig. 5A) einen dritten Transistor ($Q_7$), einen vierten Transistor ($Q_8$) und einen fünften Transistor ($Q_9$) umfaßt, die in Reihe verbunden sind, wobei das Gate sowohl des dritten, vierten als auch des fünften Transistors mit dem Drain desselben Transistors verbunden sind, das Gate des dritten Transistors ($Q_7$) mit dem Gate des genannten ersten Transistors ($Q_{10}$) verbunden und das Gate des fünften Transistors ($Q_9$) mit dem Gate des zweiten Transistors ($Q_{11}$) verbunden sind.

5. Phasenstarrer Regelkreis nach Anspruch 2, bei welchem die die Vorspannung zuführende Einrichtung (Fig. 6A) umfaßt:

einen dritten Transistor ($Q_7$) mit einem Gate, das mit dem Gate des ersten Transistors ($Q_{10}$) verbunden ist,

einen vierten Transistor ($Q_9$), mit einem Gate, das mit dem Gate des zweiten Transistors ($Q_{11}$) verbunden ist, und

einen Widerstand ($R_{10}$), der zwischen dem Drain des dritten Transistors und dem Drain des vierten Transistors angeschlossen ist, wobei das Drain sowohl des dritten als auch des vierten Transistors mit dem Gate desselben Transistors verbunden sind.

6. Phasenstarrer Regelkreis nach Anspruch 2, bei welchem die die Vorspannung zuführende Einrichtung (Fig. 6B) einen dritten Transistor ($Q_{13}$) mit einem Gate, das mit dem Gate des ersten Transistors ($Q_{10}$) verbunden ist, einen vierten Transistor ($Q_{14}$), der mit dem dritten Transistor in Reihe liegt und ein Gate hat, das mit seinem Drain verbunden ist, einen vierten Transistor ($Q_{12}$), mit einem Gate, das mit dem Gate des dritten Transistors ($Q_{13}$) verbunden ist, und einen Widerstand ($R_{11}$), der in Reihe mit dem vierten Transistor ($Q_{12}$) verbunden ist, hat.

7. Phasenstarrer Regelkreis nach Anspruch 1, bei welchem die erste Schalteinrichtung einen ersten Inverter ($Q_1$, $Q_2$), der zwischen dem ersten Anschluß und dem anderen Anschluß des zweiten Kondensators ($C_2$) verbunden ist, umfaßt, und die zweite Schalteinrichtung einen zweiten und einen dritten Inverter ($Q_3$, $Q_4$; $Q_5$, $Q_6$) umfaßt, die in Reihe zwischen dem zweiten Eingangsanschluß und dem anderen Anschluß des dritten Kondensators ($C_3$) verbunden sind.

**Revendications**

1. Circuit à boucle de verrouillage de phase qui comporte:

— un comparateur de phase servant à produire un premier signal de déphasage (c) et un deuxième signal de déphasage (d) respectivement en réponse à un déphasage positif ou négatif entre un premier signal d'entrée (a) et un deuxième signal d'entrée (b),

— un filtre en boucle servant à produire une tension de commande correspondant audit déphasage, ledit filtre en boucle comprenant une première borne d'entrée servant à recevoir le premier signal de déphasage (c), une deuxième borne d'entrée servant à recevoir le deuxième signal de déphasage (d) et une borne de sortie servant à délivrer la tension de commande (e),

— un oscillateur à commande par tension commandé par ladite tension de commande, et

— un moyen de réaction connecté entre l'oscillateur à commande par tension et le comparateur de phase, caractérisé en ce que ledit filtre en boucle comprend:

un premier, un deuxième et une troisième condensateur ($C_1$, $C_2$, $C_3$) possédant chacun une paire de bornes dont une est connectée à la borne de sortie,

un moyen ($I_1$, $I_2$) servant à charger le premier condensateur ($C_1$) pendant le temps durant lequel le premier signal de déphasage (c) est produit et à décharger le premier condensateur ($C_1$) pendant le temps durant lequel le deuxième signal de déphasage (d) est produit,

un premier moyen de commutation (SWb) connecté à l'autre borne du deuxième condensateur ($C_2$) afin de délivrer un premier signal d'impulsions lorsque le premier signal de déphasage (c) est produit, et

un deuxième moyen de commutation (SWd) connecté à l'autre borne du troisième condensateur ($C_3$) afin de délivrer un deuxième signal d'impulsions lorsque le deuxième signal de déphasage (D) est produit.

2. Circuit à boucle de verrouillage de phase selon la revendication 1, où ledit moyen de charge et de décharge comprend un premier transistor ($Q_{10}$) connecté à la borne de sortie, un deuxième transistor ($Q_{11}$) connecté à la borne de sortie, et un moyen ($Q_7$, $Q_8$, $Q_9$; $Q_7$, $R_{10}$, $Q_9$; $Q_{12}$, $Q_{13}$, $Q_{14}$, $R_{11}$) servant à délivrer une tension de polarisation aux grilles respectives des premier et deuxième transistors.

3. Circuit à boucle de verrouillage de phase selon la revendication 2, où le premier transistor est un transistor à canal p ($Q_{10}$), et le deuxième transistor est un transistor à canal n ($Q_{11}$).

4. Circuit à boucle de verrouillage de phase selon la revendication 2, où le moyen délivrant la tension de polarisation comprend (figure 5A) un troisième transistor ($Q_7$), un quatrième transistor ($Q_8$) et un cinquième transistor ($Q_9$) connectés en série, la grille de chacun des troisième, quatrième et cinquième transistors étant connectée au drain de son propre transistor, la grille du troisième transistor ($Q_7$) étant connectée à la grille dudit premier transistor ($Q_{10}$), et la grille du cinquième transistor ($Q_9$) étant connectée à la grille du deuxième transistor ($Q_{11}$).

5. Circuit à boucle de verrouillage de phase selon la revendication 2, où le moyen délivrant la tension de polarisation comprend (Fig. 6A):

— un troisième transistor ($Q_7$) dont la grille est connectée à la grille du premier transistor ($Q_{10}$),
— un quatrième transistor ($Q_9$) dont la grille est connectée à la grille du deuxième transistor ($Q_{11}$), et
— une résistance ($R_{10}$) connectée entre le drain du troisième transistor et le drain du quatrième transistor, le drain de chacun des troisième et quatrième transistors étant connecté à la grille de son propre transistor.

6. Circuit à boucle en verrouillage de phase selon la revendication 2, où le moyen délivrant la tension de polarisation comprend (figure 6B) un troisième transistor ($Q_{13}$) dont la grille est connectée à la grille du premier transistor ($Q_{10}$), un quatrième transistor ($Q_{14}$) qui est connecté en série avec le troisième transistor et dont la grille est connectée au drain, un quatrième transistor ($Q_{12}$) dont la grille est connectée à la grille du troisième transistor ($Q_{13}$), et une résistance ($R_{11}$) connectée en série avec le quatrième transistor ($Q_{12}$).

7. Circuit à boucle de verrouillage de phase selon la revendication 1, où le premier moyen de commutation comprend un premier inverseur ($Q_1$, $Q_2$) connecté entre la première borne d'entrée et l'autre borne du deuxième condensateur ($C_2$), et le deuxième moyen de commutation comprend un deuxième et un troisième inverseur ($Q_3$, $Q_4$; $Q_5$, $Q_6$) connectés en série entre la deuxième borne d'entrée et l'autre borne du troisième condensateur ($C_3$).

*Fig. 1*

*Fig. 2A*

# Fig. 2B

# Fig. 3A

# Fig. 3B

0 072 751

Fig. 4

Fig. 5A

Fig. 5B

3

Fig. 6A

Fig. 6B

4